**Europäisches Patentamt**

**European Patent Office**

**Office européen des brevets**

(11) Veröffentlichungsnummer: **0 195 935**
**A2**

(19)

## (12) EUROPÄISCHE PATENTANMELDUNG

(21) Anmeldenummer: **86102244.0**

(22) Anmeldetag: **20.02.86**

(51) Int. Cl.⁴: **H 05 K 3/00**

(30) Priorität: **27.03.85 CH 1332/85**

(43) Veröffentlichungstag der Anmeldung: **01.10.86**
Patentblatt **86/40**

(84) Benannte Vertragsstaaten: **AT BE CH DE FR GB IT LI LU NL SE**

(71) Anmelder: **PPC Electronic AG, Riedstrasse 2, CH-6330 Cham (CH)**

(72) Erfinder: **Simm, Ivar Christof, Ringstrasse 10, CH-6343 Rotkreuz (CH)**

(74) Vertreter: **Scheidegger, Zwicky, Werner & Co., Stampfenbachstrasse 48 Postfach, CH-8023 Zürich (CH)**

(54) Verfahren zur Herstellung einer starre und flexible Partien aufweisenden Leiterplatte für gedruckte elektrische Schaltungen.

(57) Eine starre Isoliermaterialplatte (123) wird an den künftigen Übergangsstellen zwischen starren und flexiblen Partien der herzustellenden Leiterplatte mit durchgehenden Schlitzen (33) versehen, deren Enden innerhalb der Kontur der Platte, aber ausserhalb von künftigen Konturlinien der Leiterplatte liegen. Eine flexible Isoliermaterialfolie (121), welche elektrische Leiterbahnen (24) oder eine zur Bildung derselben dienende Kupferfolie trägt, wird auf der einen Seite der geschlitzten Platte (123) über die Schlitze (33) hinweg verlaufend angebracht. Auf der gegenüberliegenden Seite der Platte (123) werden eine massstabile Klebefolie (126) und eine Kupferfolie für die Bildung weiterer Leiterbahnen (27) ebenfalls über die Schlitze (33) hinweg verlaufend angeordnet. Nach dem Fertigstellen der aussenliegenden Leiterbahnen (24, 27) und der zugehörigen Bohrungen (29, 30) wird die künftige Leiterplatte entlang den vorgesehenen Konturlinien zugeschnitten, wobei die Enden der Schlitze (33) in der starren Isoliermaterialplatte (23) abgetrennt werden. Schliesslich wird die massstabile Klebefolie (126) entlang den Schlitzen (33) durchgeschnitten, wonach an den Stellen der flexiblen Partien der Leiterplatte die die flexible Folie (121) bedeckenden starren Teile (126') entfernt werden.

Verfahren zur Herstellung einer starre und flexible Partien
aufweisenden Leiterplatte für gedruckte elektrische Schaltungen

---

Die vorliegende Erfindung betrifft ein Verfahren zur Herstellung einer starre und flexible Partien aufweisenden Leiterplatte für gedruckte elektrische Schaltungen, bei der mindestens eine starre und mindestens eine flexible Isoliermaterialschicht sandwichartig miteinander verbunden sind, die
starre Isoliermaterialschicht lediglich Teile der flexiblen
Isoliermaterialschicht bedeckt und zumindest die flexible Isoliermaterialschicht elektrische Leiterbahnen trägt.

Leiterplatten der genannten Art wie auch verschiedene Verfahren zur Herstellung derselben sind bekannt. Mehrere
der bekannten Herstellungsverfahren gehen jeweils von einer die
künftige starre Isoliermaterialschicht bildenden Platte aus,
die grössere Abmessungen als die herzustellende Leiterplatte
aufweist. Diese Platte wird an den künftigen Uebergangsstellen
zwischen einer starren und einer flexiblen Partie der Leiterplatte mit durchgehenden Schlitzen versehen, deren Enden innerhalb der Konturen der Platte, aber ausserhalb der künftigen
Konturen der herzustellenden Leiterplatte liegen. Nachher
wird eine die künftige flexible Isoliermaterialschicht bildende flexible Folie auf einer Seite der Platte über die Schlitze
derselben hinweg verlaufend angeordnet und mittels einer dazwischen gelegten Klebefolie unter Anwendung von Druck und
Wärme mit der Platte verbunden. Die flexible Folie trägt
elektrische Leiterbahnen oder auf ihrer von der Platte abgewandten Seite eine Kupferschicht, aus welcher elektrische Leiterbahnen gebildet werden können. Anschliessend werden die
Leiterbahnen und zugehörigen Bohrungen der Leiterplatte in
üblicher Weise fertig bearbeitet, wonach die Platte und die mit
ihr verbundene flexible Folie entlang vorgesehener Konturlinien
der Leiterplatte durchgetrennt werden, wobei die Konturlinien
die Endpartien der Schlitze der Platte kreuzen. Die durch die
Schlitze und die Konturschnitte begrenzten und die künftigen

- 2 -    0195935

flexiblen Partien der Leiterplatte bedeckenden Teile der Platte werden schliesslich von der flexiblen Folie gelöst und entfernt.

Für die Herstellung von Leiterplatten mit in zwei oder mehr verschiedenen Ebenen angeordneten Leiterbahnen wird in der Regel eine starre Platte verwendet, die auf ihrer von der flexiblen Folie abzuwendenen Seite mit einer Kupferschicht kaschiert ist, welche die Bildung von Leiterbahnen erlaubt. Ebenso wird eine flexible Isoliermaterialfolie verwendet, die auf ihrer von der starren Platte abzuwendenden Seite mit einer Kupferschicht zur Bildung von Leiterbahnen kaschiert ist. Aus den genannten Kupferschichten lassen sich in bekannter Weise auf photo-chemischem Weg die gewünschten Leiterbahnen erzeugen, und durch zugehörige Bohrungen und galvanische Durchplattierung können Leiterbahnen auf der einen und auf der anderen Seite der Leiterplatte miteinander elektrisch verbunden werden. Bei dieser chemischen und galvanischen Bearbeitung machen sich die in der starren Platte erzeugten Schlitze unter Umständen störend bemerkbar, weil diese Schlitze an der von der flexiblen Folie abgewandten Seite der starren Platte offen sind und den Eintritt von Chemikalien und anderen Fremdstoffen gestatten. Dies ist besonders dann nachteilig oder gar unannehmbar, wenn die der starren Platte zugewandte Seite der flexiblen Folie bereits Leiterbahnen trägt, die sich über die Schlitze hinweg erstrecken und nicht mehr weggeätzt werden dürfen.

Zur Abhilfe gibt es daher bereits ein bekanntes Verfahren, bei dem die Schlitze in der starren Platte nicht durchgehend sondern in Form von Nuten gebildet werden, die nur an derjenigen Seite der Platte offen sind, auf welcher die flexible Isoliermaterialfolie angebracht wird. Das Eindringen von Fremdstoffen in die Nuten ist dann durch die flexible Folie verhindert. Nach der Fertigstellung der Leiterbahnen sind dann bei diesem Verfahren auf der von der flexiblen Folie abgewandten Seite der Platte zusätzliche Nuten einzufräsen, die zusammen mit den erstgenannten Nuten durchgehende Schlitze bilden, um das Entfernen der die künftigen flexiblen Partien der Leiterplatte bedeckenden Teile der starren Platte zu ermöglichen. Wenn dabei die ersten und die zweiten Nuten nicht genau übereinstimmen, ergeben sich an den Flanken der durchgehenden Schlitze unerwünschte Absätze oder Stufen. Um dies zu vermeiden, ist eine verhältnismässig hohe Präzision bei der Positionierung der ersten und der zweiten Nuten erforderlich.

Bei einem anderen bekannten Verfahren werden in der starren Platte anstelle von durchgehenden Schlitzen lediglich Rillen mit etwa V-förmigem Querschnitt zur Bildung von Sollbruchstellen erzeugt, die das spätere Ausbrechen der die künftigen flexiblen Partien der Leiterplatte bedeckenden Teile der Platte erlauben. Dies aber führt zu unebenen und meist faserigen Flanken der starren Isoliermaterialschicht an den Uebergangsstellen zwischen einer starren und einer flexiblen Partie der Leiterplatte, weshalb auch dieses Verfahren keine ideale Lösung ist.

Aufgabe der vorliegenden Erfindung ist es daher, ein verbessertes Verfahren zu schaffen, durch welches die geschilderten Nachteile bekannter Verfahren ausgeschaltet werden. Das zur Lösung der gestellten Aufgabe gefundene Verfahren ist durch die in den unabhängigen Patentansprüchen 1 und 5 definierten Verfahrensschritte gekennzeichnet.

Zweckmässige und vorteilhafte Weiterbildungen des erfindungsgemässen Verfahrens sind in den abhängigen Ansprüchen definiert.

Weitere Einzelheiten und die durch die Erfindung erzielten Vorteile ergeben sich aus der nun folgenden Beschreibung von Ausführungsbeispielen, die in den beigefügten Zeichnungen schematisiert veranschaulicht sind.

Fig. 1 zeigt im Schnitt einen Teil einer starre und flexible Partien aufweisenden Leiterplatte mit in zwei verschiedenen Ebenen angeordneten elektrischen Leiterbahnen;

Fig. 2 ist eine Draufsicht auf eine mit Schlitzen versehene starre Isoliermaterialplatte, die als Basis für die Herstellung der Leiterplatte gemäss Fig. 1 dient;

Fig. 3 stellt einen Schnitt entlang der Linie 3-3 in Fig. 2 dar;

Fig. 4 und Fig. 5 sind der Fig. 1 analoge Schnittdarstellungen, welche verschiedene Phasen der Herstellung der Leiterplatte gemäss Fig. 1 veranschaulichen;

Fig. 6 ist eine der Fig. 3 analoge Schnittdarstellung einer aus mehreren Schichten zusammengesetzten starren Platte, die zwischen Isoliermaterialschichten eingebettete zusätzliche Leiterbahnen aufweist und anstelle der Isoliermaterialplatte gemäss den Fig. 2 und 3 in der Leiterplatte nach Fig. 1 verwendbar ist;

Fig. 7 zeigt im Schnitt einen Teil einer anderen Ausführungsform einer starre und flexible Partien aufweisenden Leiterplatte mit einer Mehrzahl von in verschiedenen Ebenen angeordneten elektrischen Leiterbahnen;

Fig. 8 ist eine Draufsicht auf eine mit Schlitzen versehene starre Isoliermaterialplatte, von denen zwei für die Herstellung der Leiterplatte gemäss Fig. 7 verwendet werden;

Fig. 9 und Fig. 10 sind der Fig. 5 analoge Schnittdarstellungen, welche verschiedene Phasen der Herstellung der Leiterplatte gemäss Fig. 5 zeigen.

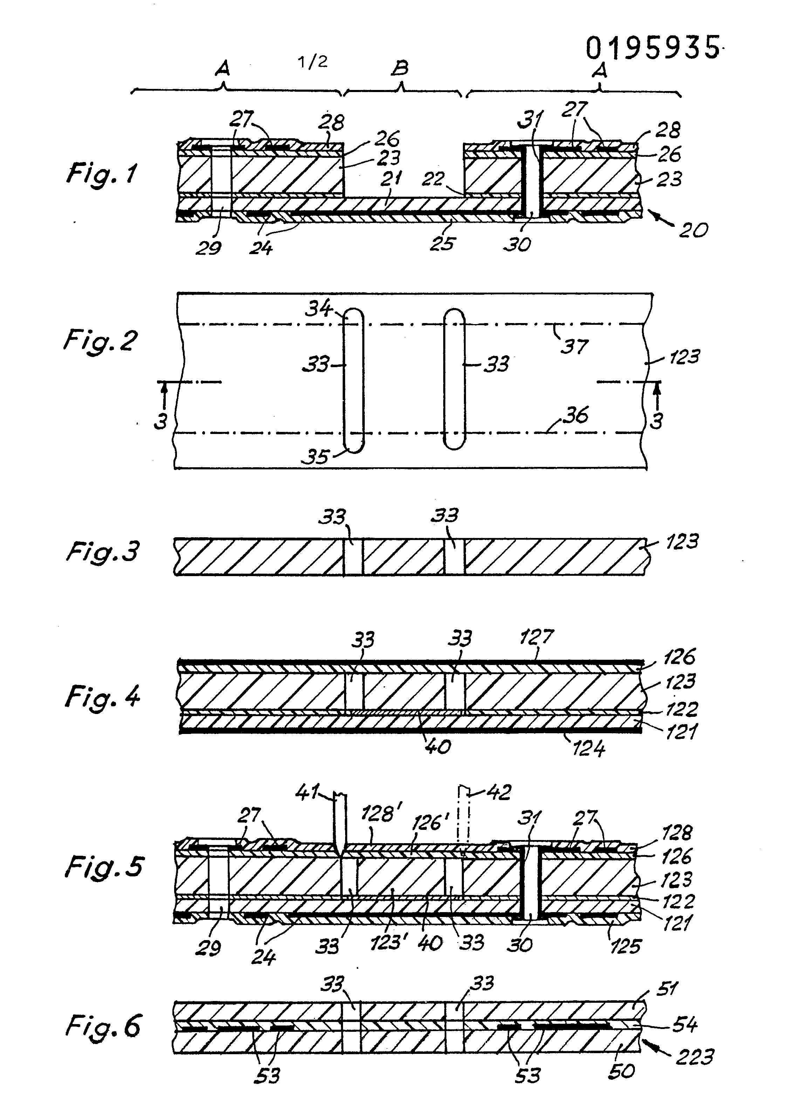

In den Schnittdarstellungen der Fig. 1, 4 bis 7, 9 und 10 sind der besseren Deutlichkeit wegen zumindest einzelne der Schichten oder Folien in übertrieben grosser Dicke im Vergleich zu den übrigen Abmessungen gezeichnet.

Die in Fig. 1 schematisch dargestellte Leiterplatte 20 weist starre Partien A und flexible Partien B auf, von welch letzteren nur eine einzige in Fig. 1 ersichtlich ist. Die Leiterplatte 20 ist aus mehreren sandwichartig übereinander angeordneten und miteinander verbundenen Schichten zusammengesetzt, und zwar wie folgt: Eine flexible Isoliermaterialschicht 21 ist mittels einer Klebeschicht 22 mit einer starren Isoliermaterialschicht 23 verbunden, welche die flexible Isoliermaterialschicht 21 nur teilweise, nämlich an den starren Partien A der Leiterplatte bedeckt. Die von der starren Isoliermaterialschicht 23 abgewandte Seite der flexiblen Isoliermaterialschicht 21 trägt elektrische Leiterbahnen 24 und eine die letzteren überdeckende Deckschicht 25 aus Isoliermaterial. An der von der flexiblen Isoliermaterialschicht 21 abgewandten Seite der starren Schicht 23 befindet sich eine dünnere Trägerschicht 26 aus Isoliermaterial, die weitere elektrische Leiterbahnen 27 und eine die letzteren überdeckende Deckschicht 28 trägt. In üblicher Weise ist die Leiterplatte 20 ferner mit durchgehenden Bohrungen 29 und 30 versehen, die den Leiterbahnen 27 bzw. 24 und 27 zugeordnet sind. Je nach Bedarf können einzelne Leiterbahnen 24 der flexiblen Schicht 21 und einzelne Leiterbahnen 27 der starren Schicht 23 miteinander durch metallische Plattierung 31 der Umfangswand der Bohrungen 30 miteinander elektrisch leitend verbunden sein.

Bei der Herstellung der Leiterplatte 20 nach Fig. 1 wird beispielsweise wie folgt verfahren:

Eine die künftige starre Isoliermaterialschicht 23 bildende starre Platte 123, deren Abmessungen grösser sind als diejenigen der herzustellenden Leiterplatte 20, wird jeweils an den künftigen Uebergangsstellen zwischen einer starren Partie

A und einer flexiblen Partie B der Leiterplatte mit durchgehenden Schlitzen 33 versehen, wie in den Fig. 2 und 3 veranschaulicht ist. Die Enden 34 und 35 jedes Schlitzes 33 liegen innerhalb der Kontur der Platte 123, aber ausserhalb von künftigen Konturlinien 36 und 37 der herzustellenden Leiterplatte 20.

Die derart vorbereitete Platte 123 wird gemäss Fig. 4 auf ihrer einen Seite mit einer Klebefolie 122 und einer flexiblen Isoliermaterialfolie 121 belegt, die ihrerseits mit einer Kupferfolie 124 kaschiert ist. Die Klebefolie 122 wird jeweils an den Stellen der künftigen flexiblen Partien B der herzustellenden Leiterplatte ausgeschnitten, und in jede der so gebildeten Aussparungen der Klebefolie 121 wird ein passend zugeschnittenes Stück Trennfolie 40 gleicher Dicke eingelegt. Auf der gegenüberliegenden Seite der Platte 123 werden eine massstabile Klebefolie 126 und eine Kupferfolie 127 angeordnet. Die flexible Isoliermaterialfolie 121, ihre Kupferkaschierung 124, die massstabile Klebefolie 126 und die Kupferfolie 127 verlaufen über die Schlitze 33 der starren Platte 124 hinweg. Unter Anwendung von Druck und Wärme werden anschliessend die flexible Folie 121 mittels der Klebefolie 122 und die Kupferfolie 127 mittels der nichtfliessenden Klebefolie 126 mit der starren Platte 123 fest verbunden, wobei die Schlitze 33 der Platte 123 hermetisch verschlossen werden.

Nachher werden aus den Kupferfolien 124 und 127 in üblicher Weise die gewünschten Leiterbahnen 24 bzw. 27 auf photo-chemischem Weg gebildet. Dann werden die den Leiterbahnen zugeordneten Bohrungen 29 und 30 erzeugt und - sofern erforderlich - die Durchplattierungen 31 auf galvanischem Weg gebildet. Bei allen diesen Bearbeitungen sind die Schlitze 33 der Platte 123 gegen Eindringen von Fremdstoffen, insbesondere Aetzlösung und Elektrolyt, geschützt.

Gemäss Fig. 5 werden nachher über die fertiggestellten Leiterbahnen 24 und 27 Deckfolien 125 und 128 aus Isoliermaterial laminiert, die je an ihrer den Leiterbahnen zugewandten Seite mit einem (nicht dargestellten) Kleber beschichtet sind. Es folgen nun die Konturschnitte der Leiterplatte 20 entlang den vorgesehenen Konturlinien 36 und 37 (Fig. 2), wobei die Enden 34 und 35 der Schlitze 33 der Platte 123 abgetrennt werden. Schliesslich werden mit einem Schneidewerkzeug 41 bzw. 42 auf der von der flexiblen Folie 121 abgewandten Seite der Platte 123 die Deckfolie 128 und die massstabile Klebefolie 126 entlang den Schlitzen 33 durchgetrennt, und zwar genau an den künftigen Uebergangsstellen zwischen den starren Partien A und den flexiblen Partien B der herzustellenden Leiterplatte, wie in Fig. 5 gezeigt ist. Hierdurch werden die die flexiblen Partien B bedeckenden Teile 123', 126' und 128' der Platte 123 und der Folien 126 und 128 abgetrennt, wonach diese Teile zusammen mit dem Trennfolienstück 40 mühelos entfernt werden können, um die fertige Leiterplatte 20 gemäss Fig. 1 zu erhalten.

Die für die Herstellung der Leiterplatte 20 benutzten Materialien haben zweckmässig die folgenden Eigenschaften:

Die starre Platte 123 besteht vorzugsweise aus glasfaserverstärktem Epoxyharz und weist eine Dicke von z.B. 1,6 mm auf. Die flexible Isoliermaterialfolie 121 besteht vorzugsweise aus Polyimid und hat eine Dicke im Bereich von 15 bis 150 µm. Die Klebefolie 122 besteht zweckmässig aus modifiziertem Epoxyharz und hat eine Dicke im Bereich von 25 bis 50 µm. Die massstabile Klebefolie 126 besteht vorzugsweise aus einem Glasfasergewebe, das mit nicht vollständig ausgehärtetem Epoxyharz imprägniert ist. Solche Klebefolien, die beim Verpressen keinen oder nur einen sehr geringen Harzfluss zeigen, sind unter der Bezeichnung "no-flow Prepreg" im Handel. Die Kupferschichten 124 und 127 haben beispielsweise eine Stärke von etwa 35 µm, und die Deckfolien 125 und 128 mit einer Dicke im Bereich von 50 bis 70 µm bestehen zweckmässig aus Polyimid. Anstelle der Deckfolien 125 und 128 können andere Deckschichten, wie z.B. aufgesprühte Lackschichten, verwendet werden.

Für die Herstellung einer gegenüber Fig. 1 modifizierten Leiterplatte, bei welcher in einer einzigen Ebene angeordnete Leiterbahnen 24 genügen, wird in der in Fig. 4 dargestellten Verfahrensphase die Kupferfolie 127 weggelassen, so dass dann die Isoliermaterialfolie 126 allein die Schlitze 33 der starren Platte 123 überdeckt und bei der weiteren Bearbeitung der Leiterplatte das Eindringen von Fremdstoffen in die Schlitze 33 verhindert.

Wenn hingegen die Leiterplatte in mehr als zwei Ebenen liegende elektrische Leiterbahnen aufweisen soll, kann dies dadurch erzielt werden, dass anstelle der quasi homogenen starren Platte 123 gemäss Fig. 3 eine geschichtete Platte 223 gemäss Fig.6 verwendet wird, die mindestens zwei starre Isoliermaterialschichten 50 und 51 sowie dazwischen angeordnete Leiterbahnen 53 aufweist. Die beiden starren Isoliermaterialschichten 50 und 51 sind miteinander durch eine massstabile Klebeschicht 54 verbunden, in welche die Leiterbahnen 53 eingebettet sind. Selbstverständlich könnte die Platte 223 eine noch grössere Anzahl von starren Isoliermaterialschichten und dazwischen angeordnete Leiterbahnen und Klebeschichten aufweisen. Bei der Herstellung der starre und flexible Partien aufweisenden Leiterplatte wird die geschichtete starre Platte 223 genau gleich mit Schlitzen 33 versehen und weiter verwendet wie mit Bezug auf die quasi homogene Platte 123 beschrieben wurde.

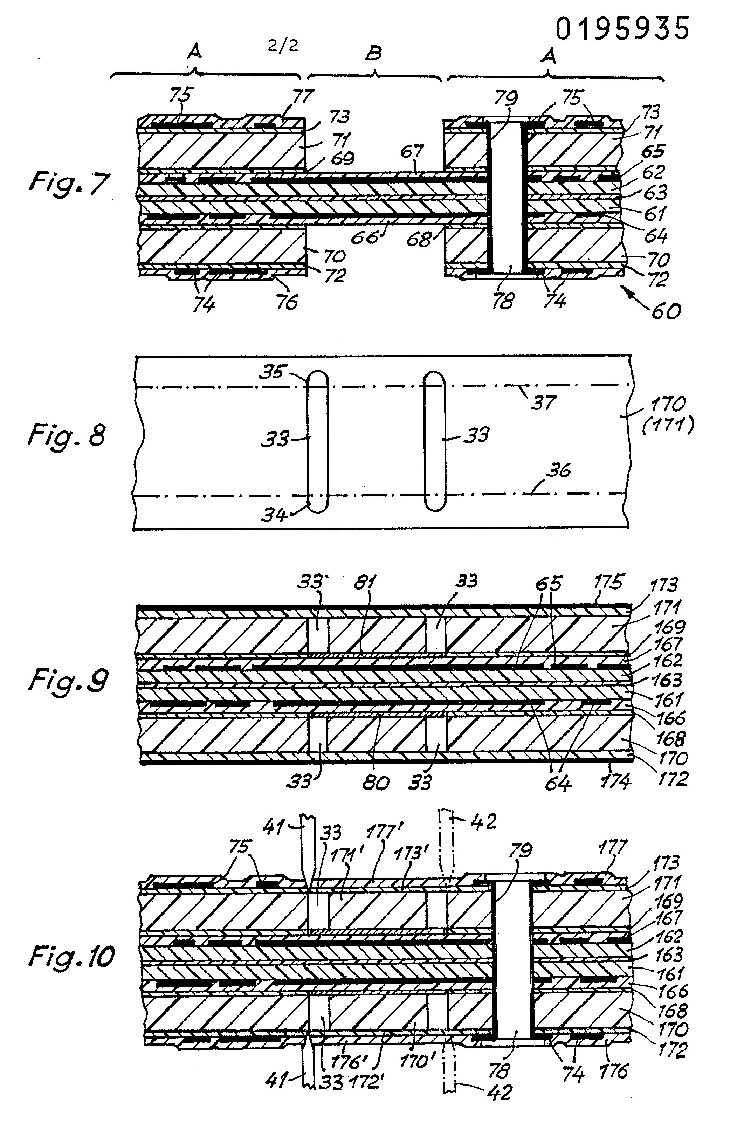

Eine andere Ausführungsart einer starre und flexible Partien aufweisenden Leiterplatte mit in mehr als zwei Ebenen angeordneten Leiterbahnen ist in Fig. 7 veranschaulicht. Die dort dargestellte Leiterplatte 60 weist den folgenden Aufbau auf:

Zwei flexible Isoliermaterialschichten 61 und 62 sind durch eine beidseitig mit einem (nicht dargestellten) Kleber versehene Zwischenschicht 63 miteinander verbunden. An den voneinander abgewandten Seiten tragen die flexiblen Schichten 61 und 62 je ein Leiterbahnbild 64 bzw. 65 und eine die Leiterbahnen überdeckende Deckschicht 66 bzw. 67 aus Isoliermaterial. Gewünschtenfalls können die flexiblen Schichten zusätzlich auch an den einander zugekehrten Seiten mit Leiterbahnen versehen sein. Die Deckschichten 66 und 67 sind je mittels einer Klebeschicht 68 bzw. 69 mit einer starren Isoliermaterialschicht 70 bzw. 71 verbunden, die sich nur über die
starren Partien A der Leiterplatte 60 erstreckt. An den von
den flexiblen Schichten 61 und 62 abgewandten Seiten der
starren Isoliermaterialschichten 70 und 71 befindet sich je
eine dünnere Trägerschicht 72 bzw. 73 aus Isoliermaterial, die
weitere elektrische Leiterbahnen 74 bzw.75 und eine diese
überdeckende Deckschicht 76 bzw. 77 trägt. Die Leiterplatte
60 ist ferner mit durchgehenden Bohrungen 78 versehen, die
gewünschtenfalls Durchplattierungen 79 zum elektrischen Verbinden von in verschiedenen Ebenen angeordneten Leiterbahnen
aufweisen können.

Bei der Herstellung der Leiterplatte 60 nach Fig. 7 wird beispielsweise wie folgt verfahren:

Zwei starre Isoliermaterialplatten 170 und 171, deren Abmessungen grösser als diejenigen der herzustellenden Leiterplatte 60 sind, werden jeweils an den künftigen Uebergangsstellen zwischen einer starren Partie A und einer flexiblen Partie B der Leiterplatte mit durchgehenden Schlitzen 33 versehen, wie in den Fig. 8 und 9 gezeigt ist. Die Enden 34 und
35 jedes Schlitzes 33 liegen innerhalb der Konturen der Platten 170 und 171, aber ausserhalb von künftigen Konturlinien
36 und 37 der herzustellenden Leiterplatte 60.

Flexible Isoliermaterialfolien 161 und 162 z.B. aus Polyimid,
die je an mindestens einer ihrer Flachseiten mit einer Kupferfolie kaschiert sind, werden zur Erzeugung der elektrischen
Leiterbahnen 64 und 65 in üblicher Weise photo-chemisch bearbeitet, wonach man über die Leiterbahnen jeder flexiblen
Folie 161 bzw. 162 eine Deckfolie 166 bzw. 167 aus Isoliermaterial laminiert, die an ihrer den Leiterbahnen zugewandten Seite mit einem (nicht dargestellten) Kleber beschichtet ist.

Weiter werden zwei Klebefolien 168 und 169 aus modifiziertem
Epoxyharz in der Weise vorbearbeitet, dass sie jeweils an den
Stellen der künftigen flexiblen Partien B der herzustellenden
Leiterplatte 60 ausgeschnitten werden.

Nachher wird die in Fig. 9 dargestellte sandwichartige
Schichtung gebildet. Diese enthält von unten nach oben: Eine
massstabile Klebefolie 172, die an ihrer nach unten gekehrten
Seite eine auflaminierte Kupferfolie 174 trägt; die mit
Schlitzen 33 versehene erste starre Platte 170; die Klebefolie
168, welche an den Stellen der künftigen flexiblen Partien B
der Leiterplatte ausgeschnitten ist, wobei in jede Aussparung
der Klebefolie 168 ein Trennfolienstück 80 gleicher Dicke eingelegt wird; die mit den Leiterbahnen 64 und der Deckfolie
166 versehene flexible Isoliermaterialfolie 161; eine beidseitig mit Kleber beschichtete Deckfolie 163 aus Isoliermaterial; die mit den Leiterbahnen 68 und der Deckfolie 167 versehene flexible Isoliermaterialfolie 162; die Klebefolie 169,
die an den Stellen der künftigen flexiblen Partien B der Leiterplatte ausgeschnitten ist, wobei in jede Aussparung der
Klebefolie 169 ein Trennfolienstück 81 gleicher Dicke eingelegt wird; die mit Schlitzen 33 versehene zweite starre Platte 171, wobei die Schlitze 33 beider Platten 170 und 171
übereinstimmende Lagen haben; eine massstabile Klebefolie
173, die an ihrer nach oben gewandten Seite eine auflaminierte Kupferfolie 175 trägt. Aus Fig. 9 ist ersichtlich, dass
die verschiedenen Folien, mit Ausnahme der Klebefolien 168
und 169, über die Schlitze 33 der starren Platten 170 und
171 hinweg verlaufen. Unter Anwendung von Druck und Wärme
werden die übereinandergeschichteten Folien und Platten dann
miteinander verbunden, wobei die Schlitze 33 der Platten 170
und 171 hermetisch verschlossen werden.

Aus den aussenliegenden Kupferfolien 174 und 175 werden
nachher die gewünschten äusseren Leiterbahnen 74 bzw. 75 in
üblicher Weise auf photo-chemischem Weg erzeugt. Dann werden
die den Leiterbahnen zugeordneten Bohrungen 78 und gegebenenfalls die Durchplattierungen 79 auf galvanischem Weg gebildet. Bei diesen photo-chemischen und galvanischen
Bearbeitungen sind die Schlitze 33 der Platten 170 und 171
gegen das Eindringen von Aetzlösung und Elektrolyt geschützt.

Gemäss Fig. 10 werden nachher über die fertiggestellten äusseren Leiterbahnen 74 und 75 Deckfolien 176 und 177 aus Isoliermaterial laminiert, die je an ihrer den Leiterbahnen zugewandten Seite mit einem (nicht dargestellten) Kleber beschichtet sind. Dann folgen die Konturschnitte der Leiterplatte 60 entlang den vorgesehenen Konturlinien 36 und 37 (Fig.8),
wobei die Enden 34 und 35 der Schlitze 33 der beiden Patten
170 und 171 abgetrennt werden. Schliesslich werden mit einem
oder mehreren Schneidewerkzeugen 41 bzw. 42 auf beiden Aussenseiten die Deckfolien 176 und 177 und die massstabilen
Klebefolien 172 und 173 entlang den Schlitzen 33 durchgetrennt, und zwar genau an den künftigen Uebergangsstellen
zwischen den starren Partien A und den flexiblen Partien B
der herzustellenden Leiterplatte 60, wie in Fig. 10 gezeigt
ist. Hierdurch werden die die flexiblen Partien B bedeckenden
Teile 170', 171', 172', 173', 176' und 177' der Platten 170,
171 und der Folien 172, 173, 176 und 177 abgetrennt, wonach
diese Teile zusammen mit den Trennfolienstücken 80 und 81
mühelos entfernt werden können, um die fertige Leiterplatte
60 gemäss Fig. 7 zu erhalten.

Zweckmässig haben die für die Herstellung der Leiterplatte
60 verwendeten Platten und Folien etwa die gleichen technologischen Eigenschaften und Dickenabmessungen wie mit Bezug
auf das erste Ausführungsbeispiel beschrieben wurde.

Es ist möglich und für manche Verwendungszwecke der Leiterplatte angezeigt, anstelle mindestens einer der quasi homogenen starren Platten 170 und 171 jeweils eine geschichtete Platte zu verwenden, wie sie unter Bezugnahme auf Fig. 6 beispielsweise beschrieben wurde. Ebenso ist es möglich, zwischen den starren Platten mehr als zwei flexible Folien anzuordnen, die je auf mindestens einer Seite elektrische Leiterbahnen tragen.

Die beschriebenen Herstellungsverfahren haben gegenüber bekannten Verfahren zur Herstellung von starre und flexible Partien aufweisenden Leiterplatten die folgenden hauptsächlichen Vorteile: An den Uebergangsstellen zwischen starren Partien A und flexiblen Partien B der Leiterplatte weisen die starren Schichten 23 bzw. 70 und 71 glatte, saubere und vor allem faserfreie Schnittflächen auf, die durch die Schlitze 33 gebildet sind. Während der Bearbeitung der aussenliegenden Kupferfolien 124, 127 bzw. 174, 175 sind die Schlitze 33 der starren Platte 123 bzw. 223 oder 170 und 171 hermetisch überdeckt, so dass das Eindringen von Fremdstoffen, wie Aetzlösung oder Elektrolyt, verhindert ist. Das Heraustrennen der die künftigen flexiblen Partien B bedeckenden Teile 123', 126', 128' oder 170', 171', 172', 173', 176', 177' geschieht durch einfaches Schneiden entlang den Uebergangsstellen zwischen starren und flexiblen Partien der Leiterplatte; ein Tiefenfräsen oder Herausbrechen entfällt. Alle Schritte des Herstellungsverfahrens können beim Leiterplattenhersteller durchgeführt werden.

P a t e n t a n s p r ü c h e

1. Verfahren zur Herstellung einer starre und flexible Partien aufweisenden Leiterplatte für gedruckte elektrische Schaltungen, bei der mindestens eine starre und mindestens eine flexible Isoliermaterialschicht sandwichartig miteinander verbunden sind, die starre Isoliermaterialschicht lediglich Teile der flexiblen Isoliermaterialschicht bedeckt und zumindest die flexible Isoliermaterialschicht elektrische Leiterbahnen trägt, gekennzeichnet durch die folgenden Verfahrensschritte:

a) eine die künftige starre Isoliermaterialschicht (23) bildende Platte (123; 223) mit grösseren Abmessungen als diejenigen der herzustellenden Leiterplatte (20) wird jeweils an den künftigen Uebergangsstellen zwischen einer starren Partie (A) und einer flexiblen Partie (B) der Leiterplatte mit durchgehenden Schlitzen (33) versehen, deren Enden (34, 35) innerhalb der Kontur der Platte (123; 223), aber ausserhalb von künftigen Konturlinien (36, 37) der herzustellenden Leiterplatte liegen,

b) mindestens eine die künftige flexible Isoliermaterialschicht (21) bildende flexible Folie (121), welche elektrische Leiterbahnen (24) oder eine Kupferfolie (124) zur Bildung von Leiterbahnen trägt, wird auf einer Seite der Platte (123; 223) über die Schlitze (33) derselben hinweg verlaufend angebracht und mit der Platte verbunden,

c) auf der von der flexiblen Isoliermaterialfolie (121) abgewandten Seite der Platte (123; 223) wird eine Schutzfolie (126) ebenfalls über die Schlitze (33) der Platte hinweg verlaufend angebracht und mit der Platte verbunden,

d) die elektrischen Leiterbahnen (24, 27) und zugehörigen
   Bohrungen (29, 30) der Leiterplatte werden fertiggestellt,

e) die starre Platte (123; 223) und die mit ihr verbundenen
   Folien (121, 124, 126) werden entlang vorgesehener Konturlinien (36, 37) der Leiterplatte durchgetrennt, wobei die
   Konturlinien die Endpartien (34, 35) der Schlitze (33) der
   Platte kreuzen,

f) die Schutzfolie (126) wird entlang den Schlitzen (33) der
   Platte (123) an den Uebergangsstellen zwischen starren und
   flexiblen Partien der Leiterplatte durchgeschnitten, und
   dann werden die die künftigen flexiblen Partien (B) der Leiterplatte bedeckenden Teile (123', 126') der starren Platte
   (123; 223) und der Schutzfolie (126) entfernt.

2. Verfahren nach Anspruch 1, dadurch gekennzeichnet, dass
die flexible Isoliermaterialfolie (121) auf ihrer von der
starren Platte (123) abgewandten Seite eine Kupferfolie (124)
trägt, aus welcher bei dem Verfahrensschritt d) elektrische
Leiterbahnen (24) gebildet werden.

3. Verfahren nach Anspruch 2, dadurch gekennzeichnet,
dass die Schutzfolie (126) aus Isoliermaterial besteht und auf
ihrer von der starren Platte (123) abgewandten Seite eine
Kupferfolie (127) trägt, aus welcher bei dem Verfahrensschritt
d) weitere elektrische Leiterbahnen (27) gebildet werden.

4. Verfahren nach einem der Ansprüche 1 bis 3, dadurch
gekennzeichnet, dass die bei dem Verfahrensschritt a) verwendete starre Platte (223) aus mindestens zwei starren Isoliermaterialschichten (50, 51) mit dazwischen liegenden
elektrischen Leiterbahnen (53) gebildet wird.

5. Verfahren zur Herstellung einer starre und
flexible Partien aufweisenden Leiterplatte für gedruckte
elektrische Schaltungen, bei der mindestens
zwei starre Isoliermaterialschichten und mindestens eine dazwischen liegende flexible Isoliermaterialschicht sandwichartig miteinander verbunden sind, die starren Isoliermaterialschichten lediglich Teile der flexiblen Isoliermaterialschicht bedecken und zumindest die flexible Isoliermaterialschicht elektrische Leiterbahnen trägt, gekennzeichnet durch
die folgenden Verfahrensschritte:

a) zwei die künftigen starren Isoliermaterialschichten (70, 71)
   bildende Platten(170, 171) mit grösseren Abmessungen als
   diejenigen der herzustellenden Leiterplatte (60) werden jeweils an den künftigen Uebergangsstellen zwischen einer
   starren Partie (A) und einer flexiblen Partie (B) der Leiterplatte mit durchgehenden Schlitzen (33) versehen, deren
   Enden (34, 35) innerhalb der Konturen der Platten (170,171),
   aber ausserhalb der künftigen Konturlinien (36, 37) der
   Leiterplatte liegen,

b) mindestens eine die künftige flexible Isoliermaterialschicht
   (61, 62) bildende flexible Folie (161, 162), welche elektrische Leiterbahnen (64, 65) trägt, wird zwischen den beiden
   Platten (170, 171) über die Schlitze (33) derselben hinweg
   verlaufend angeordnet und mit den Platten verbunden, wobei
   die Schlitze (33) der beiden Platten (170, 171) in übereinstimmende Lagen gebracht werden,

c) auf der von der flexiblen Isoliermaterialfolie (161, 162)
   abgewandten Seite jeder starren Platte (170, 171) wird eine
   Schutzfolie (172, 173) ebenfalls über die Schlitze (33) der
   betreffenden Platte hinweg verlaufend angebracht und mit
   derselben verbunden,

d) die elektrischen Leiterbahnen (74, 75) und zugehörigen Bohrungen (78) der Leiterplatte werden fertiggestellt,

e) die miteinander verbundenen Platten (170, 171) und Folien
   (161, 162, 172, 173) werden entlang vorgesehener Konturlinien (36, 37) der Leiterplatte durchgetrennt, wobei die Konturlinien die Endpartien (34, 35) der Schlitze (33) der beiden starren Platten (170, 171) kreuzen,

f) die Schutzfolie (172, 173) auf jeder Platte (170, 171) wird entlang den Schlitzen (33) der betreffenden Platte an den Uebergangsstellen zwischen starren und flexiblen Partien der Leiterplatte durchgeschnitten, und dann werden die die künftigen flexiblen Partien (B) der Leiterplatte bedeckenden Teile (170', 171', 172', 173') der beiden starren Platten (170, 171) und der Schutzfolien (172, 173) entfernt.

6. Verfahren nach Anspruch 5, dadurch gekennzeichnet, dass jede Schutzfolie (172, 173) aus Isoliermaterial besteht und auf ihrer von der betreffenden starren Platte (170, 171) abgewandten Seite eine Kupferfolie (174, 175) trägt, aus welcher bei dem Verfahrensschritt d) weitere elektrische Leiterbahnen (74, 75) gebildet werden.

7. Verfahren nach einem der Ansprüche 5 und 6, dadurch gekennzeichnet, dass mindestens eine der bei dem Verfahrensschritt a) verwendeten starren Platten (170, 171) aus mindestens zwei starren Isoliermaterialschichten (50, 51) mit dazwischenliegenden elektrischen Leiterbahnen (53) gebildet wird.

8. Leiterplatte für gedruckte elektrische Schaltungen, hergestellt nach dem Verfahren gemäss einem der Ansprüche 1 bis 4.

9. Leiterplatte für gedruckte elektrische Schaltungen, hergestellt nach dem Verfahren gemäss einem der Ansprüche 5 bis 7.

0195935

Fig. 1

Fig. 2

Fig. 3

Fig. 4

Fig. 5

Fig. 6

**Fig. 7**

**Fig. 8**

**Fig. 9**

**Fig. 10**